# EUROPEAN PATENT SPECIFICATION

(11) **EP 0 444 943 B1**
(45) Date of publication and mention of the grant of the patent: **21.05.1997**
(21) Application number: 91301680.4
(22) Date of filing: 28.02.1991
(51) Int. Cl.: H01L 21/18, H01L 21/302

(54) **A method of manufacturing a bonded wafer**
Verfahren zur Herstellung von verbundenen Halbleiterplättchen
Méthode de fabrication d'un substrat lié

(30) Priority: 28.02.1990 JP 45776/90; 28.02.1990 JP 45778/90
(43) Date of publication of application: 04.09.1991
(73) Proprietor: SHIN-ETSU HANDOTAI COMPANY LIMITED, Chiyoda-ku Tokyo (JP)
(72) Inventor: Ito, Tatsuo, Joyuetsu-shi, Niigata-ken (JP); Nakano, Masami, Nishi-shirakawa-gun, Fukushima-ken (JP); Nakazato, Yasuaki, Kousyoku-shi, Nagano-ken (JP); Uchiyama, Atsuo, Chiisagata-gun, Nagano-ken (JP); Kida, Takahiro, Kousyoku-shi, Nagano-ken (JP); Takei, Tokio, Nagano-shi, Nagano-ken (JP); Yoshizawa, Katsuo, Kousyoku-shi, Nagano-ken (JP); Fukami, Masao, Nagano-shi, Nagano-ken (JP)
(74) Representative: Pacitti, Pierpaolo A.M.E.

(56) References cited:
- EP-A- 182 032
- EP-A- 0 192 488
- EP-A- 0 337 556
- FUJITSU-SCIENTIFIC AND TECHNICAL JOURNAL. vol. 24, no. 4, 1988, KAWASAKI JP pages 408 - 417; Hiroshi GOTOU et al.: "SOI-device on bonded wafer"
- PATENT ABSTRACTS OF JAPAN vol. 14, no. 99 (E-893) 22 February 1990, & JP-A-01 302740 (TOSHIBA CORP.) 06 December 1989,
- PATENT ABSTRACTS OF JAPAN vol. 13, no. 525 (E-850) 22 November 1989, & JP-A-01 215041 (SONY CORP.) 29 August 1989,
- PATENT ABSTRACTS OF JAPAN vol. 12, no. 447 (E-685) 24 November 1988, & JP-A-63 175484 (YOKOGAWA ELECTRIC CORP.) 19 July 1988,
- EXTENDED ABSTRACTS OF THE 20TH CONF. ON SOLID STATE DEVICES AND MATERIALS 24 August 1988, TOKYO pages 197 - 200; XU XIAO-LI et al.: "Si on SiO2 by Solid State Diffusion Bonding (SSDB) technology"

## Description

### Background of the Invention

### (1) Field of the Invention

This invention relates to a method of manufacturing a bonded wafer, especially a warpless bonded wafer having a high degree of flatness.

### (2) Description of the Prior Art

As a method for forming a single crystal semiconductor film over a dielectric substrate, there has been known a technology which is characterized by epitaxially growing a single crystal silicon film or the like over a single crystal sapphire substrate. In this technology, however, because there exists a disagreement in lattice constant between the dielectric substrate and the silicon single crystal which is grown in vapor phase, numerous crystal defects occur in the silicon vapor-phase grown layer, and for this reason this technology is of no practical use.

Another conventional technology of providing a single crystal film on a dielectric substrate is characterized by first forming a thermally oxidized oxide film across the surface of the silicon substrate, laying a polycrystal or amorphous silicon film over this oxide film, and applying to this an energy beam such as an electron beam or a laser beam in a manner such that the beam spot thereon is shifted along lines all in one and the same direction to thereby melt the silicon film, and then cooling and solidifying the film to obtain a monolithic single crystal film.

Now, the technology of changing the silicon polycrystal film over the oxide film into the single crystal film by means of the laser beam or the like is disclosed, for example, in Japanese Patent Kokoku 62-34716. According to this publication, a single crystal projection is monolithically formed at a corner of the periphery of a single crystal silicon substrate, and with this projection as the seed crystal, single crystallisation of the polycrystal film is effected. Although localised growth of a single crystal is possible, owing to an interaction between the single crystal projection and the molten silicon oxide film, it is difficult to obtain a silicon single crystal film of practical use.

Under the circumstances, bonded wafers having Si-on-insulation structure (SOI structure) have come to draw the attention of the scientists in the field. An SOI bonded wafer is made of two silicon mirror wafers which are joined together face to face, with an oxide layer formed between them. An example of an SOI bonded wafer is disclosed in EP-A-337556 wherein use is made of a relatively massive mechanical support to hold the silicon flat and warpfree during particular thickness-reduction processes. The processes of EP-A-337556 do not employ differential stress cancellation in the manner of the present invention, as will subsequently be detailed.

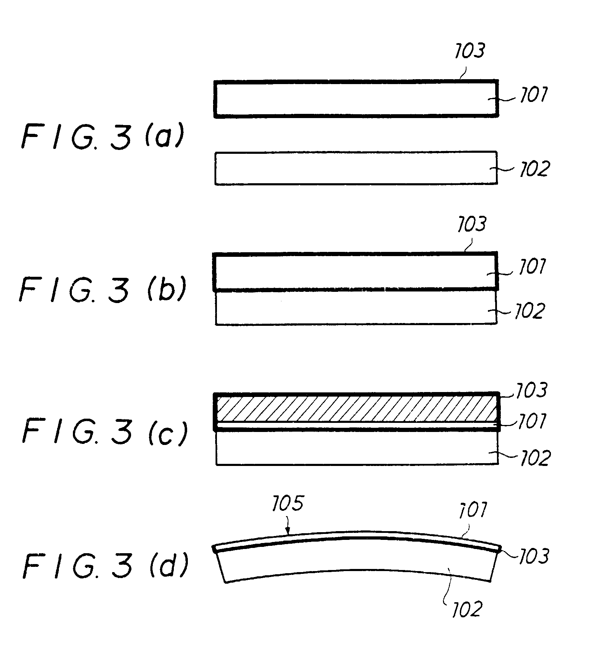

Fig 3 shows an example of another procedure of manufacturing such silicon bonded wafer (ie a procedure different from that of EP-A-337556). At the stage (a), two semiconductor mirror wafers of silicon single crystal are prepared. The one (hereinafter referred to as "the bond wafer") 101 whose upper face, as viewed in Fig 3, is to be made into the device formation face is subjected to a thermal oxidation treatment whereby a thin oxide film 103 of silicon dioxide is formed throughout the entire surface, or on both main surfaces, of the bond wafer 101. The other mirror wafer 102 shall be referred to as "the base wafer", and is employed mainly for a protective purpose, that is, for securing mechanical strength of the final bonded wafer.

At the next stage (b), the two wafers 101 and 102 are put together, as shown in Fig. 3, and heated to a predetermined temperature, 500°C for example, to thereby bind them eternally. Then, at the stage (c), the upper face of the bond wafer 101 is ground until the thickness of the bond wafer 101 becomes several µm (the hatched portion of the bond wafer 101 is ground off). As the result, a bonded wafer 105 is obtained, as shown at (d) of Fig. 3.

### (Problems the Invention seeks to solve)

When, for example, the bonded wafer 105 was made in the manner as described above, the intermediate silicon dioxide layer is fixed between the two wafers 101, 102 at high temperature, as shown at (b) of Fig. 3. As the bonded wafer 105 is cooled thereafter, residual stress (tensile stress mainly) is accumulated in the wafer, since the coefficient of thermal expansion (or the coefficient of thermal contraction) of silicon single crystal is greater than that of silicon dioxide. When the bond wafer 101 is ground thinner, the residual stress contained in the bond wafer 101 is mostly relieved and becomes negligible compared with that in the base wafer 102, and as a result, the residual stress in the base wafer 102, especially that accumulated near the oxide film 103, causes the bonded wafer 105 to warp as shown at (d) of Fig. 3. In particular, the base wafer 102 without the oxide film 103 shrinks greater than the bond wafer 101. Thus, the bonded wafer 105 arches in a manner such that the side of the bond wafer 101 forms the convex, and the magnitude of warpage is generally 100 - 200 µm.

If the bonded wafer 105 is warped, as shown at (d) of Fig. 3, problems are experienced when the bonded wafer 105 has to be attached to the level block of a grinder by suction or with wax for further grinding of the bond wafer 101, because it is difficult to hold the warped wafer onto the flat surface of the level block, and in the later processes, such as photolithography process, after the further grinding, the warped bonded wafer 105 causes such inconveniences as difficulty in its setting to various wafer stages and deformed circuit pattern exposure onto a photoresist.

A method was proposed wherein the bond wafer and/or the base wafer are/is warped beforehand in a manner that compensates the warpage which occurs as the bonded wafer is thermally oxidized and cool. However, this method does not sufficiently remove the warpage from the bonded wafer.

Now, in a bonded wafer, it is necessary that the bonding strength between the bond wafer and the base wafer is sufficiently high throughout the bonded face; otherwise, areas where bonding is not effected called voids are formed in the bonding interface, which results in poor yield of products. In order to achieve complete bonding between the wafers, and for certain other reasons, the faces of wafers to be bonded to each other is polished to a specular gloss finish.

Incidentally, the voids in a bonded wafer can be detected by means of such known methods as infrared ray transmission method, ultrasonic flaw detection method, and X-ray diffraction micrography method.

In the process of manufacturing bonded wafers, each bonded wafer is etched with an etching liquid such as hydrogen fluoride for the purpose of removing the oxide film formed over the wafer surfaces. If the corrosion resistance of the bonding interface against the etching liquid is not sufficiently strong, an inconvenience experienced is that the bonding interface fails to hold the wafers together and a pattern formed on the bond wafer can come off during the device formation processes.

The present invention was made in view of the above-stated problems; therefore, it is an object of the invention to provide a method for manufacturing a bonded wafer which can provide a warpless bonded wafer having a high degree of flatness even after the bond wafer is ground thin.

It is another object of the invention to provide a method for manufacturing a bonded wafer that can provide a bonded wafer in which the bonding strength between the bond wafer and the base wafer is sufficiently high throughout the bonded face, and the corrosion resistance of the bonding interface against an etching liquid is sufficiently great.

There are three conceivable manners in which a bonded wafer is produced wherein an oxide layer is sandwiched between the bond and base wafers: that is, (1) form an oxide layer over the base wafer, and attach the bond wafer onto the oxide layer of the base wafer; (2) form an oxide layer over the bond wafer, and attach the base wafer onto the oxide layer of the bond wafer; (3) form an oxide layer over the bond wafer and the base wafer, and attach the two wafers together with the oxide layer in between.

An example of manner (1) is disclosed in EP-A-182032, in which the base wafer is initially filmed with oxide while the bond wafer is initially unoxidised. This is opposite to the procedure of the present invention and produces inferior results, as will be detailed below.

The present inventors had supposed that probably one of these manners would be more effective than others in giving high bonding strength between the wafers and improving corrosion resistance of the bonding interface against the etching liquid. To confirm their supposition, the inventors conducted various experiments and came to a conclusion that if the manner (2) is observed the best result is obtained.

### SUMMARY OF THE INVENTION

In order to attain the objects of the invention, the inventors propose a method of manufacturing a bonded wafer which comprises the steps of: preparing a first mirror wafer at least one face of which has specular gloss; preparing a second mirror wafer at least one face of which has specular gloss; forming a first oxide film over at least one face of the second mirror wafer which face has specular gloss; joining the first and second mirror wafers face to face in a manner such that the first oxide film formed on a specular-glossed face of the second mirror wafer is sandwiched between a specular-glossed face of the first mirror and the second mirror wafer; heating the thus joined wafers at a high temperature to thereby create bonding strength between the two wafers; subjecting the two joined wafers to a thermal oxidation treatment to thereby form a second oxide film all over the joined wafers; the method being characterised by the step of grinding the external face of the second wafer until the second wafer becomes a thin film.

In an embodiment of the invention, the first oxide film is formed all over the second wafer.

Further, it is proposed as a still more preferred embodiment that the first oxide film is formed only over one face of the second wafer which face has specular gloss.

It is also preferable if the thickness of the second oxide film is nearly equal to the thickness of the first oxide film.

In a case where the bonded wafer of the invention is used as a substrate for a semiconductor device such as a semiconductor integrated circuit, the wafer to be ground and made into a thin film should be selected from those which have physical and electric properties that correspond to the properties of the semiconductor device. Incidentally, the thickness of the oxide film which is formed after the bonding of the wafers is preferably close to the thickness of the oxide film sandwiched between the two wafers.

### (Effects of the Invention)

According to the invention, the first wafer (base wafer) has its both faces covered with an oxide film as of the time when the second wafer (bond wafer) is ground and thinned to a film, so that the thermal contraction coefficient at one face of the first wafer is roughly equal to that at the other face thereof; accordingly, the residual stress distribution in the first wafer becomes such that the magnitude of the residual stress at one face is roughly equal to that at the other face. As a result, the first wafer does not warp and a warpless bonded wafer having a high degree of flatness is obtained.

### Brief Description of Drawings

These together with other objects and advantages which will become subsequently apparent reside in the details of operation as more fully hereinafter described and claimed, reference being made to the accompanying drawings forming a part hereof.
Fig. 1 is a drawing useful in explaining the procedure of the first embodiment of the invention;
Fig. 2 is a graph showing the result of a measurement of the warpage of the bonded wafers of the invention compared with the result obtained of the bonded wafers fabricated by a conventional method;
Fig. 3 is a drawing useful in explaining the procedure of a conventional method for manufacturing a bonded wafer;
Fig. 4 is a drawing useful in explaining the procedure of the second embodiment of the invention; and
Fig. 5 is a graph showing the result of a tension test conducted on different kinds of bonded wafers.

### (Embodiments of the invention)

Now, embodiments of the invention will be described with reference to the attached drawings.

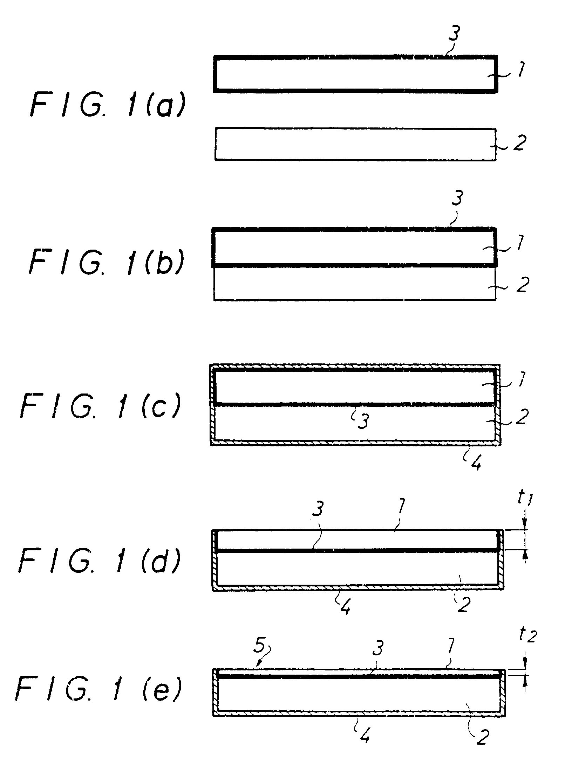

Fig. 1 is useful to explain the manufacturing method according to a first embodiment of the invention. In Fig. 1 reference numeral 1 designates a single crystal silicon mirror wafer whose lower face (as viewed in Fig. 1) is mirror-finished, and whose upper face after grinding and polishing is made into a device formation face. At step (a) in Fig. 1, this wafer, which is hereinafter called "the bond wafer 1", is subjected to an oxidation treatment whereby a silicon dioxide film 3 having a thickness of about 0.5 µm is formed all over the surface of the bond wafer 1. Besides this bond wafer 1, a single crystal silicon mirror wafer 2 whose upper face (as viewed in Fig. 1) is mirror-finished is prepared. This wafer 2 is hereinafter referred to as "the base wafer 2".

At step (b) in Fig. 1, the base wafer 2 and the bond wafer 1 are joined together with the mirror-finished faces meeting each other. Then, the combined wafers 1, 2 are heated at about 500°C in a nitrogen gas atmosphere to thereby create adhesive strength between the wafers. The laminated wafers 1, 2 are then heated at about 1100°C in an oxidizing atmosphere for approximately 120 minutes (thermal oxidation treatment). As a result, a silicon dioxide film 4 (hatched in Fig. 1), which is about 0.5 µm in thickness, is formed all over the laminated wafers 1, 2.

Next, the laminated wafers 1, 2 are cooled, and the exposed side of the bond wafer 1 is ground until the thickness of the bond wafer 1 is reduced to a predetermined value t1, e.g. 6 µm [primary grinding; step (d) in Fig. 1].

As it is earlier explained with reference to Fig. 3, when the laminated wafers are cooled, the wafers 1, 2 shrink more than the silicon dioxide films 3, 4 do, and as a result residual stress is created in the lamination. However, unlike the case of Fig. 3, in the present embodiment, since the both faces of the base wafer 2 are covered with either the oxide film 3 or the oxide film 4 which films are of roughly the same thickness (about 0.5 µm), the residual stress balances between the two faces of the base wafer 2 so that the thermal shrinkage amount at one face of the base wafer 2 is roughly equal to that at the other face; consequently, the base wafer 2 does not warp.

The bond wafer 1 having a thickness t1 [Fig. 1 (d)] is further ground until the thickness is reduced to a predetermined value t2, e.g. 3 µm (secondary grinding). Thus, a bonded wafer 5 shown at (e) in Fig. 1 is obtained.

Since the base wafer 2, whose thickness accounts mostly for the overall thickness of the bonded wafer 5, scarcely warps, the bonded wafer 5 does not warp either, and it will have a high degree of flatness. Consequently, in the subsequent processes the bonded wafer 5 facilitates smooth operation; for example, the bonded wafer 5 allows itself to be sucked by vacuum without fail.

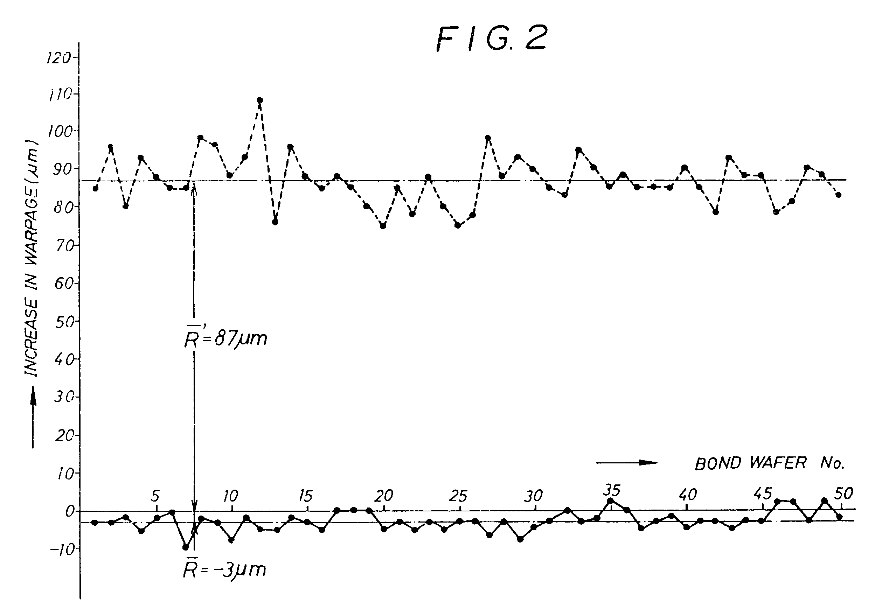

In Fig. 2, the solid kinked line represents the result of actual measurement of the warpage of fifty bonded wafers obtained by the method of the invention. The axis of abscissa represents bonded wafer Nos. (No.1 through No. 50); the axis of ordinate represents the amount of warpage by which it increased as a result of the primary grinding. The dashed kinked line in Fig. 2 represents the result of actual measurement of the warpage of fifty bonded wafers obtained by a conventional method.

According to the graphs in Fig. 2, the average value R' of the increase in warpage in the case of the bonded wafers obtained by a conventional manufacturing method was 87 µm; whereas the average R of the increase in warpage in the case of the bonded wafers of the present embodiment was -3µm, which is insignificantly small. Thus, the method of the present invention as described in this embodiment proved to attain the objects of the invention.

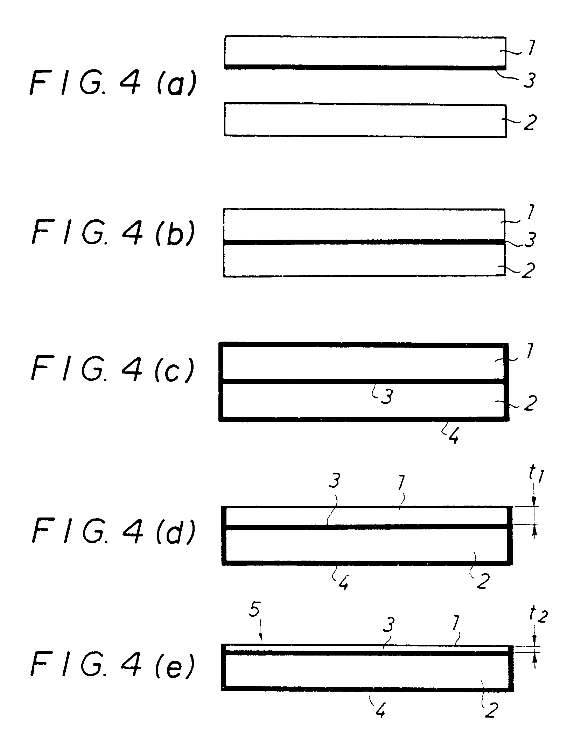

Now, with reference to Fig. 4, the manufacturing method according to a second embodiment of the invention will be explained. In Fig. 4, the reference numerals identical to those in Fig. 1 designate the same elements of the first embodiment; therefore, for example, reference numeral 1 designates a single crystal silicon mirror wafer whose lower face (as viewed in Fig. 4) is mirror-finished, and whose upper face after grinding and polishing is made into a device formation face. At step (a) in Fig. 4, this wafer, i.e., the bond wafer 1, is subjected to an oxidation treatment whereby a silicon dioxide film 3 having a thickness of about 0.5µm is formed over the lower face thereof. Besides this bond wafer 1, a single crystal silicon mirror wafer 2, that is, a base wafer 2, whose upper face (as viewed in Fig. 4) is mirror-finished is prepared.

At step (b) in Fig. 4, the base wafer 2 and the bond wafer 1 are joined together with the mirror-finished faces meeting each other. Then, the combined wafers 1, 2 are heated at about 500°C in a nitrogen gas atmosphere to thereby create adhesive strength between the wafers. The laminated wafers 1, 2 are then heated at about 1100°C in an oxidizing atmosphere for approximately 120 minutes (thermal oxidation treatment). As a result, a silicon dioxide film 4, which is about 0.5 µm in thickness, is formed all over the laminated wafers 1, 2.

Next, the laminated wafers 1, 2 are cooled, and the exposed side of the bond wafer 1 is ground until the thickness of the bond wafer 1 is reduced to a predetermined value t1, e.g. 6 µm [primary grinding; step (d) in Fig. 4].

When the laminated wafers are cooled, the wafers 1, 2 shrink more than the silicon dioxide films 3, 4 do, and as a result residual stress is created in the lamination. However, since in the present embodiment the both faces of the base wafer 2 are covered with either the oxide film 3 or the oxide film 4 which films are of roughly the same thickness (about 0.5µm), the residual stress balances between the two faces of the base wafer 2 so that the thermal shrinkage amount at one face of the base wafer 2 is roughly equal to that at the other face; consequently, the base wafer 2 does not warp.

The bond wafer 1 having a thickness t1 [Fig. 4 (d)] is further ground until the thickness is reduced to a predetermined value t2, e.g. 3 µm (secondary grinding). Thus, a bonded wafer 5 shown at (e) in Fig. 4 is obtained.

Since the base wafer 2, whose thickness accounts mostly for the overall thickness of the bonded wafer 5, scarcely warps, the bonded wafer 5 does not warp either, and it will have a high degree of flatness.

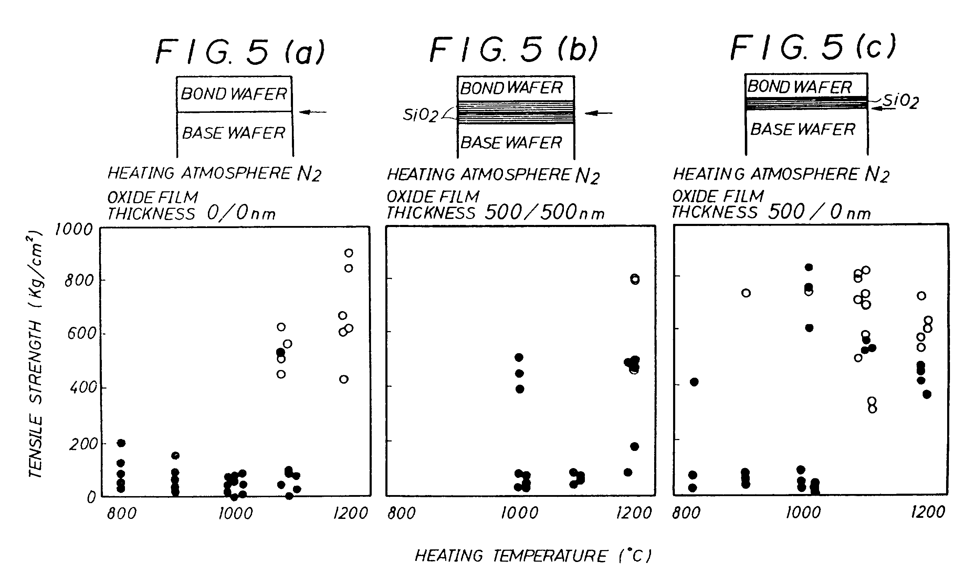

In order to compare the bonding strength of the thus obtained bonded wafer 5, a number of bonded wafers were prepared through the same procedure of this second embodiment except that the heating temperature at step (b) for wafer binding was 800 °C, 900 °C, 1000 °C, 1100 °C, and 1200°C, and the heating time was two hours. The tensile strength of each bonded wafer was measured with a tensile testing machine. The result is shown at (c) in Fig. 5. Under the same heating conditions, bonded wafers wherein no oxide film is formed between the bond and base wafers were prepared, and the similar tensile strength test was conducted on these bonded wafers, and the result is shown at (a) in Fig. 5. Further, by attaching an oxide film-covered face of a bond wafer to an oxide film-covered face of a base wafer, a number of bonded wafers were prepared wherein two layers of oxide were formed between the wafers. These were heated in the similar manner, and the same tensile strength test was conducted on these bonded wafers, and the result is shown at (b) in Fig. 5. In Fig. 5, a symbol ● designates the tensile force with which a bonded wafer was pulled when the bonded wafer was torn and divided into the bond wafer and base wafer. The other symbol ○ designates the tensile force with which a bonded wafer was pulled when the adhesive holding the bonded wafer onto the tensile testing machine failed and the bonded wafer came off the tensile testing machine.

The results shown at (c) in Fig. 5 indicate that if an oxide film is formed only over the bond wafer, as in the present invention, such that the resulting bonded wafer has one layer of the oxide in the bonding interface, and if the bonded wafer is heated at 1100 °C or higher, a bonding strength of 800 kg/cm² or greater is obtained. The results shown at (a) in Fig. 5 indicate that if there is no oxide layer at the bonding interface, the heating temperature must be 1200 °C or higher in order to obtain a bonding strength of 800 kg/cm² or greater.

The results shown at (b) in Fig. 5 indicate that if two layers of oxide are formed at the bonding interface, the heating temperature must be 1200 °C or higher in order to obtain a bonding strength of 800 kg/cm² or greater.

It follows from this comparative tests that only the method of the present invention provides a bonded wafer having a bonding strength of 800 kg/cm² or greater, under the condition that the heating temperature is not higher than 1100 °C.

Another test was conducted to find the corrosion resistance of the bonding interface of each of these bonded wafers against an etching agent (hydrogen fluoride). The result was such that the bonded wafers of the present invention retained high corrosion resistance at the bonding interface. However, the bonded wafers prepared in the manners different from the present invention did not show sufficiently high corrosion resistance at the bonding interface.

In order to compare the durability of the bonding interface against the etching agent, a bonding wafer containing two layers of the oxide at the bonding interface [(b) of Fig. 5] and a bonded wafer containing one layer of the oxide at the bondeing interface [(c) of Fig. 5] were sliced by an outer diameter saw slicing machine. Then, from each bonded wafer were cut out twenty pieces each of 2mm-square pellets, which were then placed in a 25% solution of hydrogen fluoride at 25 °C for twenty minutes. The pellets were then washed with water, dried, and the remnant bonding strength was examined in the following manner.

Using two pairs of pincettes, the bond wafer and the base wafer were pinched and pulled from each other with a small force. About a half of the pellets cut from the bonded wafer having two layers of oxide at the bonding interface were torn apart. In the case of the pellets cut from the bonded wafer having one layer of oxide at the bonding interface, none was torn apart by the pulling. Cross section of the bonding interface of these pellets of the present invention were observed with a microscope, and it was confirmed that the corrosion by the etching agent did not reach the middle portion of the bonding interface, or more particularly speaking the corrosion did not progress deep into the interface between the base wafer and the oxide layer of the bond wafer.

A bonded wafer made by the method of the present invention has another advantage. Suppose that a device such as an integrated circuit device is formed on the bond wafer of a bonded wafer by a conventional procedure. Compared with a bonded wafer in which the oxide layer is originally formed over the base wafer, the bonded wafer of the invention in which the oxide layer is originally formed over the bond wafer, provides a better dielectric strength and other electric properties to the integrated circuit device by virtue of the fact that the device formation face of the bond wafer is entirely covered with the dielectric oxide film.

Incidentally, in the two embodiments the heating for creating adhesion effect and the heating for thermal oxidation constitute two different steps in the invention, it is possible to combine the adhesion step with the oxidation step into one step.

## Claims

1. A method of manufacturing a bonded wafer (5) which comprises the steps of: preparing a first mirror wafer (2) at least one face of which has specular gloss; preparing a second mirror wafer (1) at least one face of which has specular gloss; forming a first oxide film (3) over at least one face of said second mirror wafer (1) whose face has specular gloss; joining said first and second mirror wafers (2, 1) face to face in a manner such that said first oxide film (3) formed on a specular-glossed face of said second mirror wafer (1) is sandwiched between a specular-glossed face of said first mirror wafer (2) and said second mirror wafer (1); heating the thus joined wafers (2, 1) at a high temperature to thereby create bonding strength between said two wafers (2, 1); subjecting said two joined wafers (2, 1) to a thermal oxidation treatment to thereby form a second oxide film (4) all over said joined wafers (2, 1); said method being characterised by the step of grinding the external face of said second wafer (1) until said second wafer (1) becomes a thin film.

2. A method as claimed in Claim 1 characterised in that said first oxide film (3) is formed all over said second mirror wafer (1).

3. A method as claimed in Claim 1 characterised in that said first oxide film (3) is formed only over one face of said second mirror wafer (1) which face has specular gloss.

4. A method as claimed in Claim 1 characterised in that the thickness of said first oxide film (3) is nearly equal to the thickness of said second oxide film (4).

5. A method as claimed in Claim 1 characterised in that the temperature for heating the joined wafers (2, 1) for creating bonding strength between the wafers is about 1100°C.

## Patentansprüche

1. Verfahren zur Herstellung eines Verbundwafers (5), bestehend aus den Stufen: Herstellung eines ersten Spiegelwafers (2), bei welchem wenigstens eine Fläche einen Spiegelglanz hat; Herstellung eines zweiten Spiegelwafers (1), bei welchem wenigstens eine Fläche einen Spiegelglanz hat; Ausbildung eines ersten Oxidfilms (3) über wenigstens einer Fläche des zweiten Spiegelwafers (1), dessen Fläche einen Spiegelglanz hat; Verbinden der ersten und zweiten Spiegelwafers (1, 2) Fläche auf Fläche in einer solchen Art und Weise, daß der erste Oxidfilm (3), der auf einer Spiegelglanzfläche des zweiten Spiegelwafers (1) ausgebildet ist, zwischen einer Spiegelglanzfläche des ersten Spiegelwafers (2) und dem zweiten Spiegelwafer (1) angeordnet ist; Erwärmung der so verbundenen Wafers (1, 2) unter einer hohen Temperatur, um dadurch eine Verbindungsfestigkeit zwischen den beiden Wafers (1, 2) zu schaffen; Unterwerfung der beiden miteinander verbundenen Wafers (1, 2) unter eine thermische Oxidationsbehandlung, um dadurch einen zweiten Oxidfilm (4) über die Gesamtheit der miteinander verbundenen Wafers (1, 2) auszubilden; wobei das Verfahren gekennzeichnet ist durch die Stufe eines Schleifens der Außenfläche des zweiten Wafers (1), bis das zweite Wafer (1) einen Dünnfilm ergibt.

2. Verfahren nach Anspruch 1, dadurch gekennzeichnet, daß der erste Oxidfilm (3) über der Gesamtheit des zweiten Spiegelwafers (1) ausgebildet wird.

3. Verfahren nach Anspruch 1, dadurch gekennzeichnet, daß der erste Oxidfilm (3) nur über der einen Fläche des zweiten Spiegelwafers (1) ausgebildet wird, die einen Spiegelglanz hat.

4. Verfahren nach Anspruch 1, dadurch gekennzeichnet, daß die Dicke des ersten Oxidfilms (3) nahezu gleich der Dicke des zweiten Oxidfilms (4) ist.

5. Verfahren nach Anspruch 1, dadurch gekennzeichnet, daß die Temperatur zur Erwärmung der miteinander verbundenen Wafers (1, 2) zur Schaffung der Verbindungsfestigkeit zwischen den Wafers etwa 1100°C beträgt.

## Revendications

1. Procédé pour la fabrication de substrat lié (5) comprenant les étapes suivantes :
- préparer un premier substrat miroir (2), dont au moins l'une des faces présente un poli spéculaire;
- préparer un second substrat miroir (1), dont au moins l'une des faces présente un poli spéculaire ;
- déposer un premier film d'oxyde (3) sur au moins une face dudit second substrat miroir (1), ladite face présentant un poli spéculaire ;
- assembler lesdits premier et second substrats miroirs (2,1) face à face de manière à ce que ledit premier film d'oxyde (3) déposé sur une face dudit second substrat miroir (1) présentant un poli spéculaire, soit intercalé entre une face dudit premier substrat miroir (2) présentant un poli spéculaire et ledit second substrat miroir (1);
- chauffer les deux substrats ainsi assemblés (2,1) à haute température, de manière à créer une force liante entre lesdits deux substrats (2,1);
- soumettre lesdits deux substrats assemblés (2,1) à un traitement thermique d'oxydation, de telle sorte à déposer un second film d'oxyde (4) tout autour desdits substrats assemblés (2,1),
ledit procédé étant caractérisé en ce qu'il comporte une étape de meulage de la face extérieure dudit second substrat (1) jusqu'à ce que ledit second substrat (1) devienne un film mince.

2. Procédé selon la revendication 1, caractérisé en ce que ledit premier film d'oxyde (3) est déposé tout autour dudit second substrat miroir (1).

3. Procédé selon la revendication 1, caractérisé en ce que ledit premier film d'oxyde (3) est déposé seulement sur une face dudit second substrat miroir (1), laquelle présente un poli spéculaire.

4. Procédé selon la revendication 1, caractérisé en ce que l'épaisseur du premier film d'oxyde (3) est sensiblement égale à l'épaisseur dudit second film d'oxyde (4).

5. Procédé selon la revendication 1, caractérisé en ce que la température de chauffage des substrats assemblés (2,1) de manbière à créer une force liante entre les substrats est d'environ 1100°C.
